# EUROPÄISCHE PATENTANMELDUNG

(11) **EP 2 755 456 A1**
(43) Veröffentlichungstag der Anmeldung: **16.07.2014**
(21) Anmeldenummer: 13005404.2
(22) Anmeldetag: 18.11.2013
(51) Int. Cl.: H05K 1/02, H05K 3/40, H05K 1/05, H05K 1/11, H05K 3/00

(54) **Anordnung mit einer flexiblen Leiterplatte und einer Wärmesenke**

(30) Priorität: 09.01.2013 DE 102013000169
(71) Anmelder: Carl Freudenberg KG, 69469 Weinheim (DE)
(72) Erfinder: Kurpiers, Waldemar, 68782 Brühl (DE); Cappellini, Christian, 42119 Wuppertal (DE); Luciani, Christophe, 67269 Grünstadt (DE); Johann, Rudolf, 66539 Neunkirchen (DE); Zedler, Uwe, 10243 Berlin (DE)

(57) **Zusammenfassung**

Eine Anordnung, umfassend einen Tragkörper (1), auf welchem eine flexible Leiterplatte (2, 3) angeordnet ist, wobei die flexible Leiterplatte (2, 3) eine Trägerschicht (2) aufweist, auf welcher mindestens eine elektrische Leitung (3) angeordnet ist, ist im Hinblick auf die Aufgabe, eine Anordnung der eingangs genannten Art derart auszugestalten und weiterzubilden, dass eine zuverlässige Abführung von Wärme sichergestellt ist, welche durch elektrische Bauteile erzeugt wird, dadurch gekennzeichnet, dass die elektrische Leitung (3) der flexiblen Leiterplatte (2, 3) wärmeleitend und/ oder elektrisch leitend mit dem Tragkörper (1) verbunden ist, wobei Wärme und/ oder elektrischer Strom der elektrischen Leitung (3) an den Tragkörper (1) abführbar ist.

## Beschreibung

### Technisches Gebiet

Die Erfindung betrifft eine Anordnung gemäß dem Oberbegriff des Patentanspruchs 1.

### Stand der Technik

Aus dem Stand der Technik sind flexible Leiterplatten, so genannte "Flexible Printed Circuits" (FPC), bekannt. Eine flexible Leiterplatte weist üblicherweise eine Trägerschicht aus Polyethylennaphthalat oder Polyimid auf. Auf dieser Trägerschicht sind elektrische Leitungen oder ein Netzwerk aus elektrischen Leitungen aufgebracht.

Auf einer flexiblen Leiterplatte können elektrische Bauteile, wie beispielsweise LEDs, angeordnet sein. Solche elektrischen Bauteile können als sogenannte "Surface Mounted Devices" (SMD) ausgestaltet sein. Diese Bauteile sind oberflächerlmontierte Bauteile.

Vor diesem Hintergrund besteht das Bedürfnis nach einer Anordnung, bei welcher die Wärme zuverlässig abgeführt wird, die von wärmeerzeugenden SMD-Bauteilen, wie beispielsweise LEDs, erzeugt wird.

### Darstellung der Erfindung

Der Erfindung liegt daher die Aufgabe zugrunde, eine Anordnung der eingangs genannten Art derart auszugestalten und weiterzubilden, dass eine zuverlässige Abführung von Wärme sichergestellt ist, welche durch elektrische Bauteile erzeugt wird.

Die vorliegende Erfindung löst die zuvor genannte Aufgabe durch eine Anordnung mit den Merkmalen des Patentanspruchs 1.

Erfindungsgemäß ist zunächst erkannt worden, dass der Kunststoff einer Trägerschicht einer flexiblen Leiterplatte schlecht Wärme leitet. Weiter ist erkannt worden, dass ein Tragkörper eine erhebliche Wärmemenge aufnehmen kann. Der Tragkörper fungiert aufgrund seiner Masse insoweit als Kühlkörper. Erfindungsgemäß ist die elektrische Leitung der flexiblen Leiterplatte daher wärmeleitend und/ oder elektrisch leitend mit dem Tragkörper verbunden, wobei Wärme und/ oder elektrischer Strom der elektrischen Leitung an den Tragkörper abführbar ist. Hierdurch ist eine sehr gute Wärmeableitung der Wärme von wärmeerzeugenden Bauteilen ermöglicht.

Folglich ist die eingangs genannte Aufgabe gelöst.

Die elektrische Leitung könnte zumindest bereichsweise unmittelbar am Tragkörper anliegen. Hierdurch ist ein elektrischer Kontakt geringen Widerstands und ein hocheffektiver Wärmekontakt mit dem Tragkörper möglich. Es erfolgt eine direkte Ankopplung der elektrischen Leitungen einer flexiblen Leiterplatte an einen versteifenden Tragkörper.

Vor diesem Hintergrund könnte die elektrische Leitung durch Verschweißen stoffschlüssig mit dem Tragkörper verbunden sein. Bevorzugt kann die Verbindung durch Ultraschalischweißen erfolgen. Ein Schweißprozess ist kostengünstig. Er kann rasch und ohne chemische Hilfsstoffe durchgeführt werden. Insoweit ist ein sortenreiner Aufbau der Anordnung möglich, wodurch diese leicht entsorgbar ist.

Die elektrische Leitung könnte zumindest bereichsweise durch einen Klebstoff mit dem Tragkörper verbunden sein, wobei der Klebstoff unmittelbar am Tragkörper und an der elektrischen Leitung anliegt. Bevorzugt wird ein Klebstoff eingesetzt, der als Leitkleber ausgestaltet ist.

Der Tragkörper könnte starr sein. Hierdurch ist eine Versteifung der Anordnung möglich.

Der Tragkörper könnte Aluminium aufweisen. Bevorzugt ist der Tragkörper aus Aluminiumdruckguss gefertigt. Aluminium hat sich als besonders effektiver und leichter Kühlkörper zur Abführung von Wärme erwiesen.

Die elektrische Leitung könnte aus Kupfer gefertigt sein. Kupfer ist besonders gut elektrisch leitfähig und geht mit Aluminium eine gute elektrische Leitungsverbindung und eine gute Wärmeleitungsverbindung ein.

Die flexible Leiterplatte könnte mit elektrischen Bauteilen bestückt sein. Ein solches Bauteil könnte eine LED sein, um Licht zu erzeugen.

Eine Anordnung der hier beschriebenen Art könnte als LED-Modul im Abblendlicht eines Kraftfahrzeugs verwendet werden.

Konkret ist denkbar, LED-Module in automotiven Frontlichtapplikationen einzusetzen.

Weiter ist denkbar, ein statisches Kurvenlicht, Fernlicht, Abblendlicht und Tagfahrlicht zu realisieren.

### Kurzbeschreibung der Zeichnung

In der Zeichnung zeigen
- Fig. 1: eine schematische Darstellung der Durchführung eines Verfahrens zur Herstellung einer Anordnung, bei welcher die elektrischen Leitungen aus Kupfer durch Ultraschall mit einer Trägerplatte aus Aluminium verbunden sind, und
- Fig. 2: eine schematische Darstellung einer Anordnung, bei welcher die elektrischen Leitungen aus Kupfer durch einen Klebstoff mit einer Trägerplatte aus Aluminium verbunden sind.

### Ausführung der Erfindung

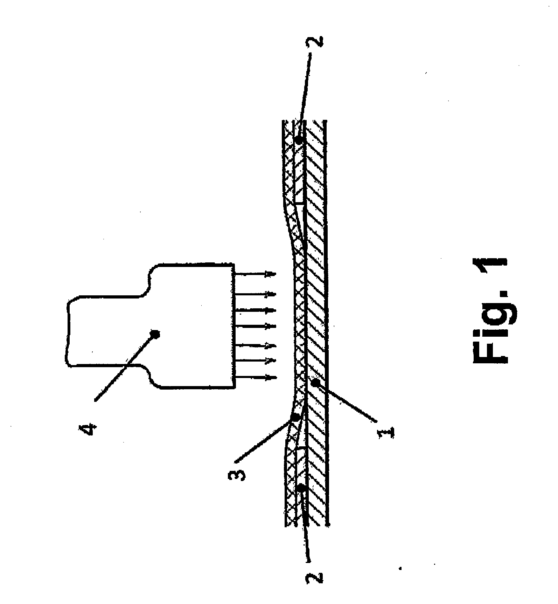

Fig. 1 zeigt eine Anordnung, umfassend einen Tragkörper 1, auf welchem eine flexible Leiterplatte 2, 3 angeordnet ist, wobei die flexible Leiterplatte 2, 3 eine Trägerschicht 2 aufweist, auf welcher mindestens eine elektrische Leitung 3 angeordnet ist.

Die elektrische Leitung 3 der flexiblen Leiterplatte 2, 3 ist wärmeleitend und elektrisch leitend mit dem Tragkörper 1 verbunden, wobei Wärme und elektrischer Strom der elektrischen Leitung 3 an den Tragkörper 1 abführbar ist. Die elektrische Leitung 3 liegt zumindest bereichsweise unmittelbar am Tragkörper 1 an. Hierzu ist ein Teil der Trägerschicht 2 entfernt, welche zwischen der elektrischen Leitung 3 und dem Tragkörper 1 liegt.

Die elektrische Leitung 3 ist durch Verschweißen stoffschlüssig mit dem Tragkörper 1 verbunden. Das Verschweißen erfolgt mit einer Sonotrode 4. Konkret wird Ultraschall eingesetzt, um die elektrische Leitung 3 aus Kupfer mit dem starren und versteifenden Tragkörper 1 aus Aluminium zu verbinden.

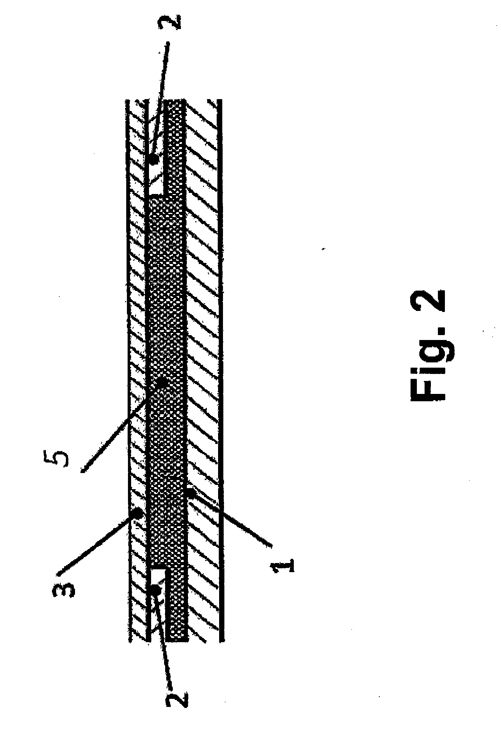

Fig. 2 zeigt eine Anordnung, bei welcher die elektrische Leitung 3 zumindest bereichsweise durch einen Klebstoff 5 mit dem Tragkörper 1 verbunden ist, wobei der Klebstoff 5 unmittelbar am Tragkörper 1 und an der elektrischen Leitung 3 anliegt. Als Klebstoff 5 wird ein Leitkleber eingesetzt.

Der Tragkörper 1 ist starr und dient als Versteifung der flexiblen Leiterplatte 2, 3. Der Tragkörper 1 weist Aluminium auf. Die elektrische Leitung 3 ist aus Kupfer gefertigt.

Die flexible Leiterplatte 2, 3 kann durch Lasern oder Stanzen bearbeitet werden. Insbesondere kann ein Teil der Trägerschicht 2 durch Stanzen oder Lasern entfernt werden. So kann eine elektrische Leitung 3 freigelegt und an den Tragkörper 1 wärmeleitend und/ oder elektrisch leitend angebunden werden.

Die flexible Leiterplatte 2, 3 weist eine Trägerschicht 2 auf, welche bevorzugt aus Polyethylennaphthalat oder Polyimid gefertigt ist. Die elektrische Leitung 3 der flexiblen Leiterplatte 2, 3 ist aus Kupfer gefertigt. Die elektrische Leitung 3 kann auch breitere Flächen aufweisen und ein Teil eines Netzwerks aus elektrischen Leitungen 3 sein, welches auf der Trägerschicht 2 aufliegt.

Auf der flexiblen Leiterplatte 2, 3 können elektrische Bauteile angeordnet sein. Die elektrischen Bauteile sind als sogenannte "Surface Mounted Devices" (SMD) ausgestaltet. Solche Bauteile sind oberflächenmontierte Bauteile. Im Gegensatz zur konventionellen Bestückung von elektrischen Leiterplatten werden diese Bauteile mit ihren Anschlussdrähten nicht in eine Platine gesteckt und auf der anderen Seite verlötet. Bei einer SMD-Technik erfolgt das Verlöten auf der gleichen Seite, auf der die Bestückung erfolgt.

## Patentansprüche

1. Anordnung, umfassend einen Tragkörper (1), auf welchem eine flexible Leiterplatte (2, 3) angeordnet ist, wobei die flexible Leiterplatte (2, 3) eine Trägerschicht (2) aufweist, auf welcher mindestens eine elektrische Leitung (3) angeordnet ist,
**dadurch gekennzeichnet, dass** die elektrische Leitung (3) der flexiblen Leiterplatte (2, 3) wärmeleitend und/ oder elektrisch leitend mit dem Tragkörper (1) verbunden ist, wobei Wärme und/ oder elektrischer Strom der elektrischen Leitung (3) an den Tragkörper (1) abführbar ist.

2. Anordnung nach Anspruch 1, **dadurch gekennzeichnet, dass** die elektrische Leitung (3) zumindest bereichsweise unmittelbar am Tragkörper (1) anliegt.

3. Anordnung nach Anspruch 1 oder 2, **dadurch gekennzeichnet, dass** die elektrische Leitung (3) durch Verschweißen stoffschlüssig mit dem Tragkörper (1) verbunden ist.

4. Anordnung nach einem der voranstehenden Ansprüche, **dadurch gekennzeichnet, dass** die elektrische Leitung (3) zumindest bereichsweise durch einen Klebstoff (5) mit dem Tragkörper (1) verbunden ist, wobei der Klebstoff (5) unmittelbar am Tragkörper (1) und an der elektrischen Leitung (3) anliegt.

5. Anordnung nach einem der voranstehenden Ansprüche, **dadurch gekennzeichnet, dass** der Tragkörper (1) starr ist.

6. Anordnung nach einem der voranstehenden Ansprüche, **dadurch gekennzeichnet, dass** der Tragkörper (1) Aluminium aufweist.

7. Anordnung nach einem der voranstehenden Ansprüche, **dadurch gekennzeichnet, dass** die elektrische Leitung (3) aus Kupfer gefertigt ist.

8. Anordnung nach einem der voranstehenden Ansprüche, **dadurch gekennzeichnet, dass** die flexible Leiterplatte (2, 3) mit elektrischen Bauteilen bestückt ist.
